# EUROPEAN PATENT APPLICATION

(11) **EP 3 800 507 A1**
(43) Date of publication of application: **07.04.2021**
(21) Application number: 19201373.8
(22) Date of filing: 04.10.2019
(51) Int. Cl.: G03F 7/20

(54) **A METHOD FOR DESIGNING A METROLOGY TARGET**

(71) Applicant: Imec VZW, 3001 Leuven (BE)
(72) Inventor: Truffert, Mr. Vincent, 3001 Leuven (BE); Ausschnitt, Mr. Christopher, 3001 Leuven (BE); Gillijns, Mr. Werner, 3001 Leuven (BE)
(74) Representative: Patent Department IMEC

(57) **Abstract**

According to the method, a library of asymmetric mark designs is provided and the response of these marks as a function of dose and focus is explored by simulation of a given process that includes lithography, for all the marks within the library or for a selected subgroup thereof, rather than by actual measurements. Based on the simulated responses, suitable mark designs are selected and included in the target. Marks are selected which enable to obtain a unique solution of an inverted parametric model linking optical characteristics obtained from the marks to the effective dose and focus. The simulation takes into account all the process parameters, so that the method allows to design a dedicated metrology target for each layer of a semiconductor process sequence.

## Description

### Field of the Invention

The present invention is related to semiconductor processing, in particular to the design of metrology targets included in lithographic masks used in the fabrication of semiconductor chips.

### State of the art.

In semiconductor manufacturing, the devices in the chip are built by combining multiple layers of patterns in various materials. The dimensions involved require a tight control of processes and patterning tools, the latter including lithography scanner tools and etch tools. Most process or tool deviations involved in patterning can be converted into an equivalent scanner dose deviation and/or focus deviation so that lithographic scanner dose and focus corrections are used in feedback loops to maintain high yield in the production process.

A known way of quantifying the effective dose and focus deviations is to use metrology targets included in the lithographic masks. A metrology target comprising two different asymmetrical marks may be used to extract dose and focus through the inversion of a parametric model that ties an optical measurement value based on the marks to the effective dose and focus. This approach is illustrated for example in documents US9766554 and WO2017/212035. The optical value may be derived from intensity measurements of light beams diffracted by diffraction gratings formed of the asymmetric marks and included in the target, or an image-based value such as the shift of the image of an asymmetric mark, determined through an overlay type measurement. The main challenge of this approach is finding a suitable set of dose and focus extraction marks which enable a unique solution. One way of finding suitable mark shapes involves printing and/or etching various mark shapes at different settings for dose and focus on a test wafer and selecting the shapes which exhibit the desired relation. However, the design space to be explored is extremely large, while the number of mark shapes that can be printed through dose and focus on a test wafer is limited. So the chances of finding suitable mark shapes are low and the related cost to detect such features is high.

Secondly, the various patterning layers, which lead to the final device, often have very different processing conditions (tool type, illumination source, photosensitive resist material etc.). Due to the different processing conditions on each layer, a given set of dose and focus extraction marks for a given layer will most likely not work on another layer. Finally, inevitable tool-related aberrations will impact the mark selection, consequently the selected marks might not perform well on another scanner tool of a scanner tool fleet.

### Summary of the invention

The invention aims to provide a method for designing a metrology target suitable for the extraction of dose and focus that does not suffer from the above-described disadvantages. This aim is achieved by the method as set out in the appended claims. According to the method, a library of asymmetric mark designs is provided and the response of these marks as a function of dose and focus is explored by simulation of a given process that includes lithography, for all the marks within the library or for a selected subgroup thereof, rather than by actual measurements. Based on the simulated responses, suitable mark designs are selected and included in the target. Marks are selected which enable to obtain a unique solution of an inverted parametric model linking optical characteristics obtained from the marks to the effective dose and focus. The simulation takes into account all the process parameters, so that the method allows to design a dedicated metrology target for each layer of a semiconductor process sequence. The simulation is also able to take into account tool-related aberrations or the representative aberrations of a complete tool fleet, so that the mark design can be done as a function of the tools used in the actual process.

The invention in in particular related to a method for designing a metrology target for semiconductor processing, the target being suitable for the extraction of the effective exposure dose and defocus in a process that includes the exposure of a substrate in a lithography tool using a lithographic mask that comprises the target, wherein the extraction is realized through the measurement of at least two optical characteristics of the target on the processed wafer, the at least two optical characteristics being obtained respectively on the basis of at least two asymmetric marks of different design included in the target, and through the inversion of a parametric model that relates the optical characteristics to the effective dose and defocus, the method comprising the steps of :
- Providing a library of asymmetric mark designs, the mark designs being characterized by a spine portion and a patterned portion adjacent one to the other, the patterned portion comprising a 1 or 2-dimensional array of regularly spaced features,
- For each mark design of the library or for each design of a subgroup of the library, simulating the process and calculating from the simulation, the relation between the optical characteristic or a value representative thereof and the effective dose and defocus at the location of a target comprising the mark design, within a predefined range (ΔE,ΔF) of the dose and defocus,
- Selecting amongst the library or subgroup of mark designs at least two different mark designs for which the calculated relation enables determining said parametric model in such a way that the inversion of the model yields a unique solution,
- Designing a metrology target for the process by including the selected mark designs in the target.
According to an embodiment, two marks are selected from the library or subgroup, for which the simulated relations between the optical characteristic and the effective dose and focus are monotonic relations within the respective predefined ranges (ΔE,ΔF).
According to an embodiment:
- the library or subgroup comprises only or a majority of mark designs for which the relation between the optical characteristic and the effective defocus at any dose within the dose range (ΔE) is parabolic or equivalent thereto, as seen in a graph that relates the optical characteristic, set out on the vertical axis, to the effective defocus set out on the horizontal axis, the relation exhibiting a minimum or maximum defined at a position on the horizontal axis and situated within the predefined defocus range (ΔF),
- the selection step includes selecting two mark designs for which the subtraction of the parabolic or equivalent relations yields a monotonic function in the predefined defocus range (ΔF),
- the mark designs whose subtraction exhibits a monotonic relation as a function of defocus are incorporated in the target.
The selection of the two marks which exhibit a parabolic or equivalent response to defocus may be based at least on whether or not the shift between the two parabolic responses is higher than a predefined minimum.

The target may be designed so as to comprise a mark having a spine portion and two patterned portions on either side of the spine portion, and wherein said two patterned portions are the patterned portions of the selected mark designs whose subtraction yields a monotonic function.

According to an embodiment, the selection of the mark designs is furthermore based on one or more of the following criteria :
- the sensitivity of the responses to dose and defocus being higher or lower than a given value,
- the signal-to-noise ratio of the responses to dose and defocus being lower than a given value,
- the printable dose and defocus ranges being higher than and overlapping said predefined ranges (ΔF, ΔE),
- the curvature of the responses to dose and defocus being higher or lower than a given value.
According to an embodiment of the method of the invention :
- for each mark design of the library or subgroup, the relation is calculated between a value representative of the optical characteristic and the effective dose and defocus at the location of a target comprising the mark design,
- the value representative of the optical characteristic is the critical dimension of a geometric feature of the patterned portion of the mark design on the processed substrate.
According to an embodiment, the library or the subgroup of target designs comprises only mark designs compatible with a predefined range of critical dimensions of printed mark features, and/or with a predefined design rule manual compiled for the process.

The invention is equally related to an apparatus for performing the method according to any one of the preceding claims, comprising
- A memory for storing a library of asymmetric mark designs,
- A simulation and calculation tool for simulating a process and calculating, for each mark design of the library or for each design of a subgroup of the library, the relation between the optical characteristic or a value representative thereof and the effective dose and defocus at the location of a target comprising a mark design,
- A selection tool for selecting amongst the library or subgroup of mark designs at least two different mark designs for which the calculated relation enables determining said parametric model in such a way that the inversion of the model yields a unique solution,
- A design tool for designing a metrology target for the process by including the selected mark designs in the target.

### Brief description of the figures

Figure 1 shows an example of asymmetric mark designs as known in the state of the art.
Figures 2a and 2b illustrate typical responses for an asymmetric mark as a function of focus deviations within a given range ΔF, and for different dose settings.
Figures 3a and 3b illustrate how the subtraction of two shifted parabolic responses yields a monotonic response.
Figure 4 illustrates data points obtained from a simulation applied in one embodiment of the method of the invention.
Figures 5a to 5c illustrate a specific way of incorporating two selected mark designs into a target designed in accordance with an embodiment of the invention.

### Detailed description of one or more embodiments of the invention

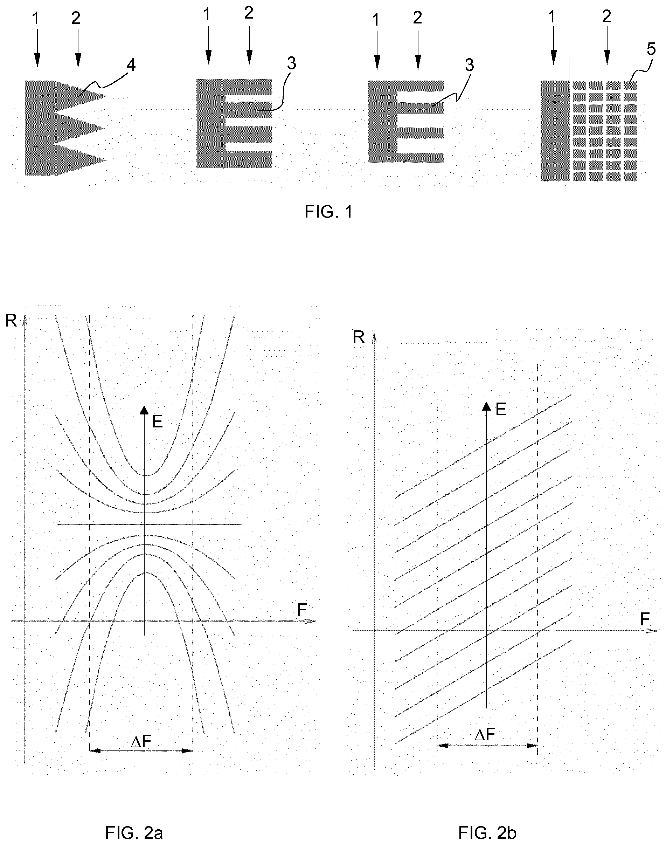

A number of typical asymmetric marks is shown in Figure 1. Each mark includes a spine portion, for example a solid rectangle 1 and a patterned portion 2, which may be a one or two-dimensional array of pattern features, such as straight or pointed legs 3 or 4 in the case of comb or dagger type marks (1-dimensional array), or rectangular dots 5 arranged in a 2-dimensional array.

The 'response' of a mark refers to an optical measurement value derived from the mark in question, for example the shift in nm between two mirrored printed or etched versions of the mark as measurable by an image based overlay tool, or an intensity-based value obtained by incorporating the mark in a set of diffraction gratings and measuring the intensity of light beams diffracted by the gratings. Both these optical measurements are known and described for example in WO2017/212035 and therefore not set out in detail in the present description.

Most mark designs have a parabolic response R to focus, as illustrated in figure 2a, in a range ΔF that is relevant for a particular process that includes lithography. In other words, deviations from a set F-value are expected to be within this range. While it is standard terminology to refer to the F value on the X-axis as 'focus', the actual meaning of the value is rather a de-focus value, i.e. a deviation from a pre-defined zero-defocus setting on the exposure tool, expressed for example in nm. In order to avoid confusion between 'defocus' and 'ΔF', the use of 'focus' for the value F will be maintained within the present detailed description. However, in the appended claims the term 'defocus' is consistently used for the same entity.

The various parabolic curves in Figure 2a correspond to different exposure dose settings. Dose is defined as the energy applied through the mask during exposure, expressed for example in mJ/cm². As indicated by the arrow, the response to dose variations is monotonic in a dose range ΔE (not indicated in the graph) applicable to the process in question, as the parabolas are related to increasing values of the dose from the parabolas at the lower end of the graph to the parabolas at the upper end. A monotonic response to both dose and focus is equally possible, as illustrated in the graph in Figure 2b : for increasing values of the dose, the response to focus is a linear monotonic function, at least within the range ΔF. While most mark designs exhibit a monotonic response to the exposure dose, a monotonic response to focus in any applicable range ΔF is rare.

Within the present context, a 'monotonic response' to dose or focus is a response exhibiting a constant sign of the first derivative in the respective ranges ΔE or ΔF. When the response to dose or focus is called 'parabolic' within the present context, this includes functions which are equivalent to a mathematical parabola, i.e. a convex or concave line exhibiting a single minimum or maximum in the respective ranges ΔE or ΔF.

As stated in the introduction, the extraction of dose and focus from a metrology measurement requires two asymmetric marks which exhibit a response that allows a unique solution for dose and focus, within a given dose and focus range applicable for a particular process. Though any behaviour of the mark response to dose or focus may lead to a unique solution, with current metrology performance the unicity of the solution is easier to find if one of the marks is monotonic in terms of its response as a function of focus and the other as a function of dose. Hereafter, these marks will also be referred to as a 'focus reader mark' and a 'dose reader mark'. Some examples of suitable responses are given in WO2017/212035. A much-preferred combination is a set of two marks which both exhibit a monotonic response as a function of dose and focus. Again with reference to the introduction, it is however very difficult to find a set of suitable marks amongst the very large group of possible combinations. Moreover, the majority of mark designs exhibits the parabolic response to focus illustrated in Figure 2a, not a monotonic response. And in most cases, when a monotonic response to focus takes place within a given focus range, this is often just the monotonic part of a wider parabolic response. In other words, the response is far removed from the minimum or maximum of the parabola (or equivalent function), which may mean that the mark is not correctly printed in the focus range in question.

The present invention solves this issue by providing a library of mark designs and by simulating the patterning of the mark features under the process conditions for which a suitable combination of asymmetric marks is required. The process parameters are included in the simulation. Furthermore, any known aberrations of the tool or representative aberration fingerprint of a fleet of tools that is to be used in the process may be taken into account in the simulation. The simulation is repeated for all or a subgroup of the mark designs, and the responses are calculated. This is followed by the selection of a suitable combination of mark designs that allows to obtain a unique solution for dose and focus. The selection is based on the evaluation of the simulated responses within a predefined range of interest for dose and focus, i.e. within ranges ΔF and ΔE as described above. According to a preferred embodiment, the simulated patterns as such are evaluated, i.e. the critical dimensions or other characteristics of the mark features, as these dimensions are representative of the optical response. This embodiment will be described in more detail later in this description.

The simulation can be performed using any existing software that allows to simulate semiconductor manufacturing process steps including lithography and etch steps. The mark designs for which the simulation is run are part of a group of predefined mark designs having different shapes and dimensions, such as comb-type marks with a variety of pitch and sizes of the features 3 or 4, and/or two-dimensional marks having various sizes of the small rectangles 5, or wherein the dots 5 have other geometries apart from the small rectangles. The library of mark designs comprises a large variation of shapes and sizes. The simulation may be applied to the library as a whole, or to a selection of marks from the library, selected for example on the basis of the design rule for the specific layer and/or on the basis of typical dimensions of the devices which are to be printed by the mask used in the particular process to which the method is applied. The verification that the mark designs are compatible with the design rules is thereby done before the fabrication of the mask, which is a particular advantage compared to existing methods for designing metrology marks.

According to preferred embodiments, the selection is based on a number of criteria for the simulated responses. Some of these criteria are described hereafter. The list is however not exhaustive, and not all criteria are necessarily applied simultaneously.

First of all, the method preferably looks for mark designs which have a monotonic response to dose and focus within the applicable ranges ΔF and ΔE. A further selection criterium that is applicable is related to the sensitivity of the response. For example, a dose reader mark having a monotonic response to both dose and focus ideally has a relatively steep, i.e. highly sensitive response to dose, but a less sensitive, i.e. less steep response to focus, while the inverse is true for a good focus reader mark. The ideal situation is a mark that exhibits high sensitivity to one parameter, either dose or focus, and zero sensitivity, i.e. a flat response, to the other. While this situation is unrealistic in most cases, the method of the invention allows to select the monotonic responses that approach this ideal as closely as possible.

Another criterium that may be applied in the selection process is the signal to noise ratio of the response curves illustrated in Figures 2a and 2b. These curves, whether simulated or obtained from measurements, are in fact curve-fitted to a number of datapoints. The SNR expresses the correspondence between the best-fitting curves and the datapoints. A more 'noisy' curve is less desirable in terms of leading to a reliable dose and focus extraction. The simulations allow to select the marks on the basis of this criterium.

A further criterium is related to whether or not the print quality of the mark features is acceptable throughout the applicable ranges ΔF and ΔE. In practice, this step verifies whether the printable focus range and the printable dose range fully overlap the applicable ranges ΔF and ΔE. The printable focus range of a mark design is the range within which the mark is reproduced on the substrate with distinct mark features (comb legs or dots), so that the optical response is measurable. In order for a response to be measurable across the range ΔF, the printable focus range needs to fully overlap the range ΔF. The same is true, mutatis mutandis, for the printable dose range.

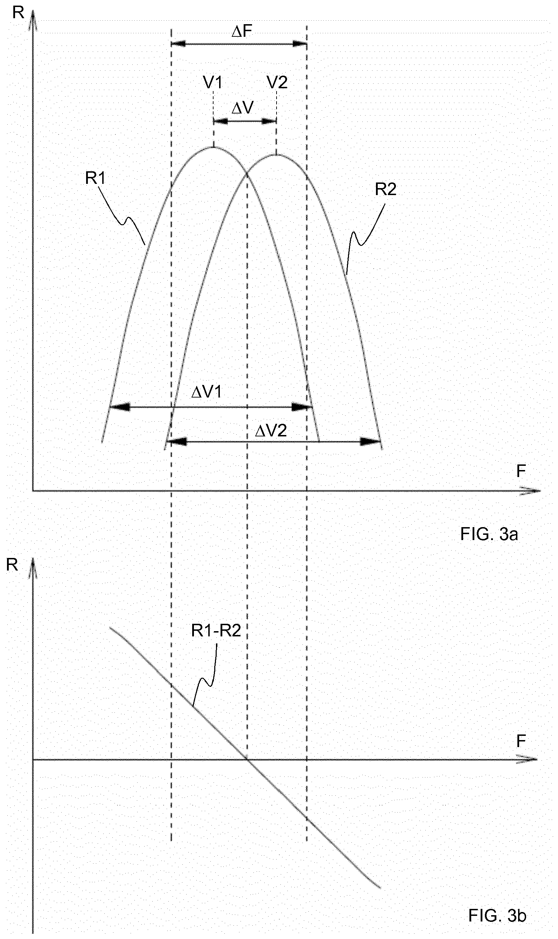

For many process conditions, it may be impossible to find a single mark that exhibits a monotonic response to focus within a given focus range ΔF. Therefore, according to the preferred embodiment, the method includes the step of identifying for a particular process two marks which have parabolic responses R1 and R2 shifted relative to each other in the direction of the X-axis. Two such responses are illustrated in Figure 3a. The responses are shown for a single value of the exposure dose. The maxima of the responses are labelled V1 and V2 and the shift between the two maxima is referred to as ΔV. Figure 3b illustrates the subtraction of the two responses R1-R2, which yields a curve that is monotonic in the range ΔF. In other words, when these two marks are included in a target, the subtraction of the two responses yields a monotonic response.

According to the preferred embodiment of the invention, the identification of the two marks having a suitable shifted parabolic response is based on the simulation of the process in question, for the library of mark designs or a subgroup thereof. Two marks are selected by simulating the various mark designs and assessing the responses on the basis of a number of criteria. Firstly, the shift between the responses needs to be higher than a predefined minimum to enable a monotonic response across the range ΔF. The shift may be measured by determining the shift between two corresponding points on the respective parabolic responses. Preferably the shift is measured as the shift between the extreme points (minima or maxima) of the parabolic responses. Also, the printable focus ranges ΔF1 and ΔF2 of the two parabolic responses are verified with respect to the range of interest ΔF. In order for the monotonic response to be measurable across the range ΔF, the printable ranges ΔF1 and ΔF2 need to fully overlap the range ΔF. For a given shape of the parabolic responses, this may be translated into a maximum shift, above which one or both of the parabolic responses does not have a printable range that fully overlaps ΔF.

Furthermore, the monotonic response R1-R2 needs to be sufficiently sensitive to focus within the range ΔF, and exhibit also a monotonic response to the exposure dose, preferably having lower sensitivity than the sensitivity to focus. The signal-to-noise ratio (see above) may be verified for the parabolic responses prior to the subtraction and/or for the monotonic response after the subtraction. Possibly the curvature of the two parabolic responses are verified as well, as the curvature has an influence on the sensitivity of the monotonic response obtained by the subtraction.

The above criteria related to the parabolic responses are verified throughout the applicable dose range ΔE, as for each value of the exposure dose, the parabolas are different (see Figure 2a).

The printable dose ranges ΔE1 and ΔE2 (not shown) are equally compared to the applicable dose range ΔE, in the same manner as the focus ranges.

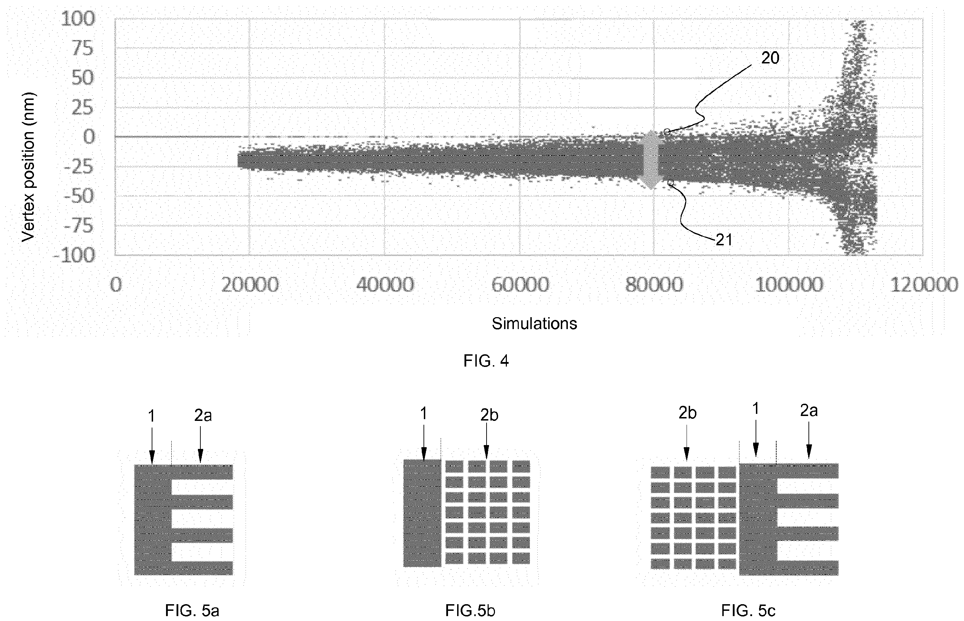

Figure 4 illustrates the result of a simulation of a process in accordance with the invention, based on a library of more than 110000 different marks. The marks are ranked on the X-axis according to any suitable ranking scheme. The Y-axis represents the position of the maximum or minimum point on the X-axis of the parabolic responses to focus (i.e. the curves of Figure 2a), on the basis of the simulation of a given process. In other words, for each mark of the library, the parabolic curve is simulated, and the maximum or minimum point determined. Each point in the graph of Figure 4 corresponds to one of the 110000 marks. The cloud of data points allows the selection of two marks which have a suitable shift, i.e. a distance between the parabolic responses that is capable of producing a suitable monotonic response when one parabolic response is subtracted from the other.

The selection process according to any embodiment of the invention can be performed automatically by a computation tool that receives data from the simulation, as well as one or more criteria which are to be met. For example, the computation tool may receive the data cloud shown in Figure 4 as input for the selection process, as well as a desired range in which the shift must be situated, and possibly other of the above-described criteria which are to be satisfied, for example related to the signal to noise ratio, sensitivity etc. For example the two data points 20 and 21 indicated in Figure 4 may be suitable choices for a given process, as the shift between these points is neither too low (e.g. higher than about 25nm) nor too high.

According to a preferred embodiment, the selection of suitable mark designs is not based on simulating the actual optical value that is set out on the Y-axis of the curves in Figure 1. As described in document US2018/0284624, and for the majority of asymmetric marks of the types shown in Figure 1, a direct relation exists between:
- the optical value (typically an image-based shift of the printed mark for an image-based target or an intensity-based value for a diffraction target) and
- one or more critical dimensions of the processed features in the asymmetrical part of the mark, for example the width of the legs of a comb-type mark obtained in a process that includes lithography.

According to the preferred embodiment, a critical dimension of a processed mark feature is calculated on the basis of the simulation and the relation between this CD and both focus and dose is determined. Due to the direct relation between the optical value and the CD, this relation will behave in the same way as the optical value, i.e. for most marks the response will also be a parabolic response as a function of focus, with the minimum or maximum at the same location along the X-axis as the parabolic curve representing the optical value. The CD therefore allows to verify the above-described criteria, including the determination of the minimum or maximum points and the selection of two marks with suitably shifted parabolic responses, as described above. The determination of the CD from the simulation is much more straightforward than simulating the optical measurement. Hence, this approach allows the results of the simulation to be obtained faster. According to this embodiment, the library of mark designs is therefore a library of 'asymmetric parts' of the actual mark designs, each asymmetric part having a different shape and/or pitch of the mark features (for example the legs of the combs or the dots of the 2-dimensional arrays). Once the asymmetric parts are selected, the asymmetric mark may be designed by adding a spine portion 1 to the asymmetric mark, as illustrated in Figure 1. The library of 'asymmetric parts' is therefore equivalent to a library of asymmetric marks. When the mark designs have been selected in accordance with the invention, according to any one of the above-described embodiments, a target is designed that includes the selected marks. The layout of the target may be in accordance with known existing layouts, for example including cross-shaped groups of asymmetric marks, as described in WO2017/212035. For instance, the selected marks may comprise two marks, one 'focus reader' and one 'mark reader', or three marks, one 'dose reader', and a pair of marks selected on the basis of the response shift as described above. The subtraction of the response of these two marks then serves as the 'focus reader'.

According to an embodiment, when two 'shifted' responses are selected, the two marks may be combined instead of including them separately. This is illustrated in Figure 5. Figures 5a and 5b illustrate two marks with a suitable shift, determined by the above described methods on the basis of simulations. The mark that may then be introduced according this specific embodiment is shown in Figure 5c. It comprises a spine portion 1 in the middle, with the respective asymmetric parts 2a and 2b of the selected marks arranged on either side of the spine portion 1.

As stated above, the method of the invention allows to design a metrology target for the extraction of effective dose and focus in accordance with the existing methodology of measuring an optical response of asymmetrical marks within the target, and by calculating a unique solution for dose and focus on the basis of the measured responses. The method is advantageous over existing methods in that suitable mark designs are selected from a large number of possible designs, without the need for fabricating a test mask. The selection is therefore more targeted than existing methods, and able to take into account various criteria for the selected marks, such as monotonicity, sensitivity and signal to noise ratio. Moreover, the method allows to take into account the parameters of the process step for which a lithographic mask is designed, the design rules of a given process step, as well as tool-related aberrations.

The method of the invention can be inserted in the existing development flow of a lithographic mask. This known flow starts with a pre-development phase based on the layout of a given chip layer, during which the design rule manual is compiled, and the illumination source is selected, as well as the resist type and a lithography tool fleet with specific known aberrations. Then the mask design phase begins, including a design rule check followed by further optimization steps such as optical proximity correction, after which the mask is fabricated. As stated in the introduction, the metrology targets included in the prior art mask design are not based on the selected source or scanner, nor on the design rule manual, but only on measurements at different dose and focus settings applied on a test mask, thereby evaluating the response of a limited number of mark designs as a function of dose and focus. As stated, the limited number of designs evaluated on the test mask may be insufficient to allow the selection of two mark designs which exhibit a suitable response and enable a unique solution to the inverted parametric model. But even if these marks are found, their compatibility with the design rules for example, or with tool-related aberrations is not known in advance, which is likely to lead to incorrect metrology results.

The method of the invention can be applied after the pre-development phase and prior to the actual mask design. The resist type and selected tool and source are incorporated in the simulation. The source selection and the design rule manual allow to estimate a range of the CDs that will be printed, so that the library may be limited to mark features which will be printed within that range, using the selected source and scanner. The marks selected according to the method of the invention are therefore known to be compatible with the source and the tool selection, and in accordance with the design rules, before the target is included in the mask design. This ensures that the metrology targets will be reliable under the process conditions for which they were designed.

The method of the invention for designing a target may include a measurement on a test mask comprising multiple mark design combinations selected from the library and based on the simulation in accordance with the invention. So contrary to the prior art, this test mask comprises only marks of which it is already known that they are suitable dose and focus readers and that they are compatible with the process conditions. The test mask will then allow to verify the predicted responses and to decide on a final selection of suitable marks. The test mask step is however not obligatory in the method of the invention.

The invention is equally related to an apparatus for performing the method of the invention. According to preferred embodiments, the apparatus comprises one or more computers which include a memory for storing the library of mark designs, a simulation tool for performing the simulations, a selection tool for selecting the mark designs, and a design tool for designing the target. The simulation and design tools may be software tools known in the art. The selection tool may be a software program tool configured to assess the simulated responses in accordance with one or more of the criteria in question.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A method for designing a metrology target for semiconductor processing, the target being suitable for the extraction of the effective exposure dose and defocus in a process that includes the exposure of a substrate in a lithography tool using a lithographic mask that comprises the target, wherein the extraction is realized through the measurement of at least two optical characteristics of the target on the processed wafer, the at least two optical characteristics being obtained respectively on the basis of at least two asymmetric marks of different design included in the target, and through the inversion of a parametric model that relates the optical characteristics to the effective dose and defocus, the method comprising the steps of :
- Providing a library of asymmetric mark designs, the mark designs being **characterized by** a spine portion (1) and a patterned portion (2) adjacent one to the other, the patterned portion comprising a 1 or 2-dimensional array of regularly spaced features (3,4,5),
- For each mark design of the library or for each design of a subgroup of the library, simulating the process and calculating from the simulation, the relation between the optical characteristic or a value representative thereof and the effective dose and defocus at the location of a target comprising the mark design, within a predefined range (ΔE,ΔF) of the dose and defocus,
- Selecting amongst the library or subgroup of mark designs at least two different mark designs for which the calculated relation enables determining said parametric model in such a way that the inversion of the model yields a unique solution,
- Designing a metrology target for the process by including the selected mark designs in the target.

2. The method according to claim 1, wherein two marks are selected from the library or subgroup, for which the simulated relations between the optical characteristic and the effective dose and focus are monotonic relations within the respective predefined ranges (ΔE,ΔF).

3. The method according to claim 1, wherein :
- the library or subgroup comprises only or a majority of mark designs for which the relation between the optical characteristic and the effective defocus at any dose within the dose range (ΔE) is parabolic or equivalent thereto, as seen in a graph that relates the optical characteristic, set out on the vertical axis, to the effective defocus set out on the horizontal axis, the relation exhibiting a minimum or maximum defined at a position on the horizontal axis and situated within the predefined defocus range (ΔF),
- the selection step includes selecting two mark designs for which the subtraction of the parabolic or equivalent relations yields a monotonic function in the predefined defocus range (ΔF),
- the mark designs whose subtraction exhibits a monotonic relation as a function of defocus are incorporated in the target.

4. The method according to claim 3, wherein the selection of the two marks which exhibit a parabolic or equivalent response to defocus is at least based on whether or not the shift between the two parabolic responses is higher than a predefined minimum.

5. The method according to claim 3 or 4, wherein the target is designed so as to comprise a mark having a spine portion (1) and two patterned portions (2a,2b) on either side of the spine portion, and wherein said two patterned portions are the patterned portions of the selected mark designs whose subtraction yields a monotonic function.

6. The method according to any one of the preceding claims, wherein the selection of the mark designs is furthermore based on one or more of the following criteria :
- the sensitivity of the responses to dose and defocus being higher or lower than a given value,
- the signal-to-noise ratio of the responses to dose and defocus being lower than a given value,
- the printable dose and defocus ranges being higher than and overlapping said predefined ranges (ΔF, ΔE),
- the curvature of the responses to dose and defocus being higher or lower than a given value.

7. The method according to any one of the preceding claims, wherein :
- for each mark design of the library or subgroup, the relation is calculated between a value representative of the optical characteristic and the effective dose and defocus at the location of a target comprising the mark design,
- the value representative of the optical characteristic is the critical dimension of a geometric feature of the patterned portion (2) of the mark design on the processed substrate.

8. The method according to any one of the preceding claims, wherein the library or the subgroup of target designs comprises only mark designs compatible with a predefined range of critical dimensions of printed mark features, and/or with a predefined design rule manual compiled for the process.

9. An apparatus for performing the method according to any one of the preceding claims, comprising
- A memory for storing a library of asymmetric mark designs,
- A simulation and calculation tool for simulating a process and calculating, for each mark design of the library or for each design of a subgroup of the library, the relation between the optical characteristic or a value representative thereof and the effective dose and defocus at the location of a target comprising a mark design,
- A selection tool for selecting amongst the library or subgroup of mark designs at least two different mark designs for which the calculated relation enables determining said parametric model in such a way that the inversion of the model yields a unique solution,
- A design tool for designing a metrology target for the process by including the selected mark designs in the target.
